# EUROPEAN PATENT APPLICATION

(11) **EP 0 639 856 A1**
(43) Date of publication of application: **22.02.1995**
(21) Application number: 94112897.7
(22) Date of filing: 18.08.1994
(51) Int. Cl.: H01L 21/3215

(54) **Method of doping a polysilicon layer and semiconductor device obtained**

(30) Priority: 20.08.1993 US 109773
(71) Applicant: TEXAS INSTRUMENTS INCORPORATED, Dallas Texas 75265 (US)
(72) Inventor: Wise,Rick L., Plano,TX 75025 (US); Johnston,Clark D., McKinney,TX 75069 (US)
(74) Representative: Schwepfinger, Karl-Heinz, Dipl.-Ing.

(57) **Abstract**

A method of uniformly doping arsenic in situ includes forming a semiconductor substrate layer (10) and depositing an optional oxide layer (12) on the semiconductor substrate layer (10). A first doped polysilicon layer (14) is deposited on the oxide layer (12). An undoped polysilicon layer (16) is deposited on the first doped polysilicon layer (14). A second doped polysilicon layer (18) is deposited on the undoped polysilicon layer (16). The polysilicon layers (14), (16), and (18) are annealed such that a dopant within the first polysilicon layer (14) and the second polysilicon layer (18) diffuses throughout all the polysilicon layers in order to form a uniformly doped undivided polysilicon layer (24) on the oxide layer (12).

## Description

### TECHNICAL FIELD OF THE INVENTION

The present invention relates in general to semiconductor device fabrication processes and more particularly to a method for uniformly doping a polysilicon layer in situ.

### BACKGROUND OF THE INVENTION

Conventional semiconductor device fabrication processes implant a dopant material, such as arsenic, in order to adjust and control the characteristics of the specific semiconductor device to be formed. Arsenic doping of polysilicon material is typically achieved by depositing undoped polysilicon and subsequently implanting arsenic into the undoped polysilicon. For applications requiring a high dopant concentration in a thick layer, high energy implantation is required. This implantation process is a costly method, both in terms of cycle time and capital equipment investment and usage. The implantation process is further undesirable in that higher concentrations of the implanted dopant occur near the surface of the layer, resulting in either high temperature anneals or extended anneal time at low temperatures to redistribute and activate the dopant.

The dopant concentration profile for the implantation process shows a higher concentration towards the top of the polysilicon layer and a lower dopant concentration at the bottom of the polysilicon layer. The uniform dopant concentration throughout the layer is difficult to achieve by the implantation method. The dopant is implanted at the surface of a layer and thus must be redistributed throughout the layer by other processes which do not provide total uniformity.

Further, deposition of a doped polysilicon layer in conventional semiconductor device fabrication processes takes a greater amount of time to complete than undoped polysilicon deposition. The deposition rate of undoped polysilicon is twenty to thirty times the deposition rate of doped polysilicon. The difference in time is due to the dopant having a higher affinity than silane to occupy the surface sites, inhibiting the decomposition of silane during deposition. Subsequent film deposition is controlled by the slower decomposition of silane. Thus, growing an in situ doped polysilicon layer in one step has a prohibitive long deposition period. Therefore, it is desirable to have a semiconductor fabrication process that achieves uniformly doped polysilicon layers without the cost and expense of conventional implantation processes or the length of time required for a full dopant deposition.

### SUMMARY OF THE INVENTION

From the foregoing, it may be appreciated that a need has arisen for a semiconductor device fabrication process that achieves uniformly doped polysilicon layers. A need has also arisen for a semiconductor fabrication process that avoids the costs and process time found in conventional implantation processes.

Various aspects of the present invention are defined in the claims.

In accordance with the present invention, a method of uniformly doping a polysilicon layer in situ is provided which substantially eliminates or reduces disadvantages and problems associated with conventional polysilicon layer doping techniques.

According to an embodiment of the present invention, there is provided a method for uniformly doping a polysilicon layer in situ that includes forming a semiconductor substrate layer and depositing an optional oxide layer on the semiconductor substrate layer. A first doped polysilicon layer is deposited on the oxide layer and an undoped polysilicon layer is deposited on the first doped polysilicon layer. A second doped polysilicon layer is deposited on the undoped polysilicon layer. The polysilicon layers are annealed to allow the dopant to diffuse throughout each doped and undoped polysilicon layer such that a uniformly doped undivided layer is formed on the oxide layer.

The method of the present invention provides various technical advantages over conventional polysilicon layer doping techniques. For example, one technical advantage is in obtaining a uniformly doped polysilicon layer. Another technical advantage is in obtaining a uniformly doped polysilicon layer through deposition techniques. Yet another technical advantage is in avoiding the expense and time costs involved with implantation doping techniques. Still another technical advantage is in overcoming the inhibition of surface decomposition of silane by the dopant. Other technical advantages are readily apparent to one skilled in the art from the following figures, descriptions, and claims.

### BRIEF DESCRIPTION OF THE DRAWINGS

For a more complete understanding of the present invention and the advantages thereof, reference is now made to the following description taken in conjunction with the accompanying drawings, wherein like reference numerals represent like parts, in which:
FIGURE 1 illustrates a deposition process for uniformly doping a polysilicon layer;
FIGURE 2 illustrates a resulting formation obtained from the uniform doping process; and
FIGURE 3 illustrates a graph of the dopant concentration levels within the uniformly doped structure.

### DETAILED DESCRIPTION OF THE INVENTION

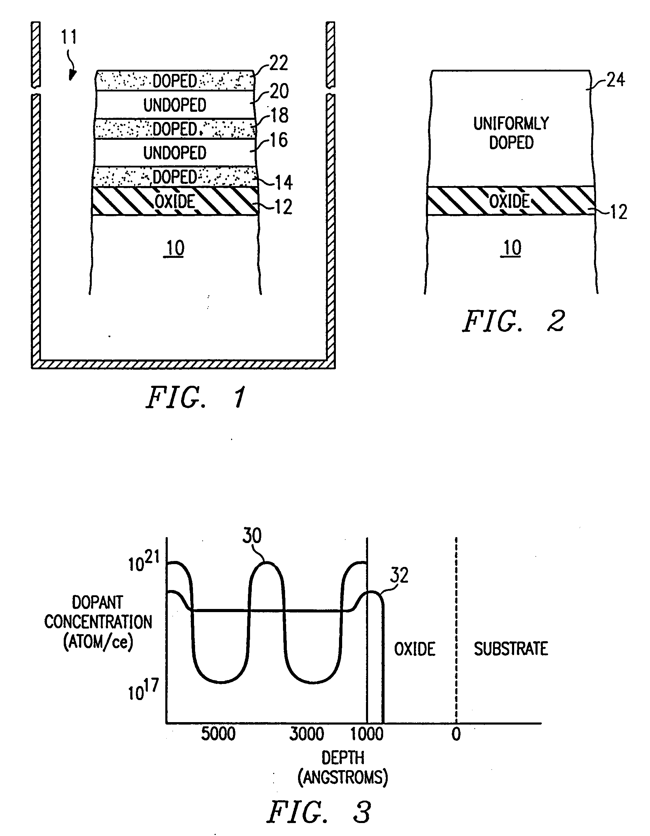

FIGURE 1 is a diagram showing the process steps of the preferred embodiment of the invention. The process begins by forming a semiconductor substrate layer 10 within a chamber 11 and depositing an optional oxide layer 12 on semiconductor substrate layer 10. A first doped polysilicon layer 14, using a dopant such as arsenic, is deposited on oxide layer 12. An undoped polysilicon layer 16 is deposited on first doped polysilicon layer 14 followed by a second doped polysilicon layer 18. Subsequent polysilicon layers may be placed on second doped polysilicon layer 18, alternating between undoped polysilicon layers 20 and doped polysilicon layers 22 as desired. Doped and undoped polysilicon layers 14, 16, 18, 20, and 22 may have varying thicknesses in order to control the amount of dopant concentration in a resulting uniformly doped layer.

A short duration temperature annealing process is performed on the structure at FIGURE 1. FIGURE 2 shows the resulting structure upon completion of the annealing process. The annealing process crystallizes the layers, activates the dopant, and allows the dopant to redistribute among doped and undoped layers 14, 16, 18, 20, and 22. The redistribution occurs rapidly during the annealing process by diffusion along grain boundaries within the layers. The redistribution of the dopant yields a uniformly doped undivided polysilicon layer 24 in place of the alternating doped and undoped layers of FIGURE 1.

FIGURE 3 is a graph of dopant concentration versus depth of the semiconductor structure of FIGURE 1. Curve 30 is the dopant concentration prior to the annealing process. The peaks in curve 30 correspond to doped polysilicon layers 14, 18, and 22. The valleys of curve 30 correspond to undoped polysilicon layers 16 and 20. Curve 30 illustrates the higher dopant concentration occurring at the doped polysilicon layers 14, 18, and 22 and the lower dopant concentration at undoped polysilicon layers 16 and 20. Curve 32 represents the dopant concentration of the semiconductor structure of FIGURE 2 after the annealing process has taken place. Curve 32 illustrates a uniform dopant concentration within uniformly doped polysilicon layer 24. Such a uniform dopant concentration was achieved using less expensive and less time consuming deposition processes, avoiding the time factor and costs found in conventional implantation processes.

Alternating doped and undoped polysilicon layers couples the conditions of dopant saturation and low deposition rate with high deposition rate of undoped layers. Deposition of alternating doped and undoped polysilicon layers is achieved by introducing both arsenic dopant gas and silicon source gas into chamber 11. Amorphous silicon, developed from the silicon gas, deposits onto oxide layer 12 and chamber 11 becomes saturated with arsenic dopant, forcing the arsenic dopant to diffuse into the deposited amorphous silicon. The arsenic dopant and silicon gas flows are discontinued, reaction chamber 11 is evacuated, and dopant atoms are desorbed from the surface of the doped amorphous silicon. Chamber 11 is then back filled to deposition pressure by a purge gas and only silicon source gas is reintroduced into chamber 11. Deposition of undoped amorphous silicon in response to the silicon gas continues until the desired layer thickness is achieved. Arsenic dopant from the previously deposited layer continues to redistribute and updiffuses into the undoped amorphous silicon layer being deposited.

After undoped deposition occurs, arsenic dopant gas is reintroduced into chamber 11 in order to deposit a doped layer on the undoped polysilicon layer. Once the second doped layer is formed, the arsenic dopant and silicon gas flows are discontinued, chamber 11 is evacuated, and dopant atoms are desorbed from the surface of the wafer as before. Alternating undoped and doped polysilicon layer deposition is repeated until the desired thickness is achieved. Since the arsenic dopant redistributes and up diffuses throughout each polysilicon layer during deposition, a uniformly doped polysilicon layer can be achieved with a minimal dopant activation and polycrystallization annealing process.

In summary, a method of uniformly doping arsenic in situ includes depositing a first arsenic doped polysilicon layer on a semiconductor substrate layer or on an oxide layer formed on the semiconductor substrate layer. An undoped polysilicon layer is deposited on the first arsenic doped polysilicon layer. A second arsenic doped polysilicon layer is deposited on the undoped polysilicon layer. An annealing process is performed on the doped and undoped polysilicon layers such that arsenic diffuses throughout the polysilicon layers to form a uniformly doped undivided polysilicon layer in place of the alternating doped and undoped polysilicon layers.

Thus, it is apparent that there has been provided, in accordance with the present invention, a method of uniformly doping arsenic in situ that satisfies the advantages set forth above. Although the preferred embodiment has been described in detail, it should be understood that various changes, substitutions, and alterations can be made herein. For example, though the method has been described using arsenic as the dopant material, any other commonly known dopant material such as phosphorous may be used. Other examples are readily ascertainable by one skilled in the art and could be made without departing from the spirit and scope of the present invention as defined by the following claims.

## Claims

1. A method of doping a polysilicon layer, comprising the steps of: forming a semiconductor substrate layer;
depositing a first doped polysilicon layer on the semiconductor substrate layer;
depositing an undoped polysilicon layer on the first doped polysilicon layer;
depositing a second doped polysilicon layer on the undoped polysilicon layer;
annealing the polysilicon layers such that a dopant within said first and second polysilicon layers diffuses throughout the polysilicon layers to form a uniformly doped layer.

2. The method of claim 1, further comprising the step of:
repeating alternate deposits of an undoped polysilicon layer and a doped polysilicon layer to obtain a desired thickness of the uniformly doped layer.

3. The method of claim 1, further comprising providing the dopant as arsenic.

4. The method of claim 1, further comprising the step of:
depositing an oxide layer on the semiconductor substrate layer to separate the uniformly doped layer from the semiconductor substrate layer.

5. The method of any preceding claim, further comprising:
placing the semiconductor substrate layer within a process chamber; introducing silicon gas and a dopant into the process chamber, the silicon gas depositing on the semiconductor substrate layer as amorphous silicon, the dopant diffusing into the amorphous silicon to form a first doped layer;
evacuating the process chamber of the silicon gas and the dopant to allow desorption of the dopant;
backfilling the process chamber to deposition pressure;
introducing silicon gas into the process chamber, the silicon gas depositing on the first doped layer to form an undoped layer of amorphous silicon, the dopant continuing to redistribute and updiffuse into the undoped layer;
introducing the dopant with the silicon gas, the silicon gas depositing on the undoped layer as amorphous silicon, the dopant diffusing into the amorphous silicon to form a second doped layer, the dopant continuing to redistribute and diffuse through the first doped layer, the second doped layer, and the undoped layer until a single doped layer develops.

6. The method of claim 5, further comprising the step of:
annealing the single doped layer to completely redistribute the dopant uniformly throughout the single doped layer to produce a single uniformly doped layer.

7. A semiconductor device, comprising:
an undivided uniformly doped polysilicon layer formed during deposition from alternating doped and undoped polysilicon layers, wherein said alternating doped and undoped polysilicon layers are annealed to redistribute a dopant throughout all layers in order to form said undivided uniformly doped polysilicon layer.

8. The semiconductor device of claim 7, wherein said dopant is arsenic.
